# FASCICULE DE BREVET EUROPEEN

(11) **EP 3 533 084 B1**
(45) Date de publication et mention de la délivrance du brevet: **23.07.2025**
(21) Numéro de dépôt: 17787435.1
(22) Date de dépôt: 24.10.2017
(51) Int. Cl.: H01L 23/48, H01L 21/60, H01L 25/065, H01L 21/98, H01L 23/31, H01L 25/10

(54) **SYSTÈME ÉLECTRONIQUE COMPORTANT UNE PUCE ÉLECTRONIQUE FORMANT BOÎTIER ET PROCÉDÉ DE FABRICATION**
ELEKTRONISCHES SYSTEM MIT EINEM ELEKTRONISCHEN CHIP ZUR FORMUNG EINER VERPACKUNG UND VERFAHREN ZUR HERSTELLUNG DAVON
ELECTRONIC SYSTEM COMPRISING AN ELECTRONIC CHIP FORMING A PACKAGE AND METHOD FOR PRODUCING SAME

(30) Priorité: 25.10.2016 FR 1660343
(43) Date de publication de la demande: 04.09.2019
(73) Titulaire: 3DIS Technologies, 31670 Labege (FR)
(72) Inventeur: GHANNAM, Ayad, 31400 Toulouse (FR)
(74) Mandataire: Argyma
(86) Numéro de dépôt international: PCT/EP2017/077134
(87) Numéro de publication internationale: WO 2018/077860

(56) Documents cités:
- CN-B- 103 632 991
- CN-B- 103 632 991
- JP-A- 2006 013 205
- JP-A- 2006 013 205
- KR-A- 20000 043 575
- KR-A- 20000 043 575
- US-A1- 2004 164 400
- US-A1- 2014 015 125

## Description

### DOMAINE TECHNIQUE GENERAL ET ART ANTERIEUR

La présente invention concerne le domaine de la fabrication d'un système électronique adapté pour être fixé à un circuit imprimé, le circuit imprimé pouvant être ensuite monté dans un appareil électronique, par exemple, un téléphone intelligent. La présente invention concerne plus particulièrement un système électronique comprenant une puce électronique formant boîtier.

De manière connue, un système électronique peut comporter plusieurs puces électroniques qui sont montées dans un boitier pour former une interface entre les puces électroniques et le circuit imprimé, connu de l'homme du métier sous sa désignation anglaise « Printed Circuit Board » (PCB). A cet effet, le boitier comporte des pattes de connexion.

Afin de pouvoir améliorer les performances d'un tel système électronique, il est nécessaire de diminuer ou d'éliminer les éléments parasites générés par les connexions qui relient les différentes puces électroniques au boitier. A cet effet, il est souhaitable de réduire les longueurs électriques de ces connexions en réduisant la distances entre les puces et en miniaturisant le boiter. Aussi, il a été proposé d'empiler verticalement les puces électroniques dans un même boîtier afin de diminuer davantage les pertes.

Cependant, cette miniaturisation est difficile à atteindre à cause des limitations des techniques actuelles d'assemblage. En effet, la plupart des techniques d'assemblage nécessitent de fabriquer un boitier, placer les puces électroniques dans le boitier, connecter lesdites puces électroniques au boîtier en utilisant des fils micro-soudés et à encapsuler l'ensemble pour le protéger de son environnement. L'utilisation de fils micro-soudés engendre de fortes pertes, ce qui présente un inconvénient.

Par ailleurs, il a été proposé d'éliminer le boitier et d'utiliser une puce électronique comme boitier afin qu'elle puisse être directement soudée sur un circuit imprimé en utilisant des billes conductrices positionnées sur la puce électronique. Un tel procédé de solidarisation par retournement est connu de l'homme du métier sous sa désignation anglaise « flip-chip ».

De manière connue, on parle alors d'un boitier à l'échelle d'une puce dite « CSP » (Chip Scale Package) puisque le boîtier a exactement la même taille que la puce électronique. Bien que cette technique permette de miniaturiser un boîtier, elle reste limitée à une unique puce électronique par boîtier. De plus, ce type de boîtier ne permet pas une intégration hétérogène (système ayant plusieurs composants électroniques différents) ni une intégration tridimensionnelle (empilement de puces électroniques).

Pour éliminer cet inconvénient, il a été proposé d'utiliser un dispositif d'interposition, appelé également « interposeur », qui comprend une face avant et une face arrière et qui comporte des connecteurs en face avant, des connecteurs en face arrière et des chemins traversants, connus sous leur désignation anglaise « Through Silicon Via », reliant les connecteurs en face arrière aux connecteurs en face avant. L'utilisation d'un tel dispositif d'interposition augmente le temps et le coût de fabrication de systèmes électroniques et peut dégrader leurs performances électriques.

Pour éliminer cet inconvénient, il a été proposé d'amincir fortement une puce fille, en la montant sur une puce mère, en déposant une couche de passivation et de planarisation et en les connectant ensembles à l'aide d'interconnexions métalliques planaires. Amincir la puce fille à une épaisseur inférieure à 30µm est nécessaire pour permettre la planarisation de la surface du système à l'aide de la couche de passivation et l'application des techniques conventionnelles de photolithographie pour la réalisation des interconnexions métalliques planaires. Une telle planarisation devient difficile à réaliser quand l'épaisseur de la puce fille ou l'épaisseur totale d'un empilement de puces filles est supérieur à 30µm, rendant ainsi extrêmement difficile l'application desdites techniques de photolithographie, donc la réalisation des interconnexions métalliques. Un fort amincissement est ainsi toujours nécessaire, ce qui augmente la complexité de manipulation et de fabrication des systèmes.

On connait également dans l'art antérieur par la demande de brevet CN 103 632 991 B une méthode de fabrication d'un système électronique comportant des bosses de connexion formées par croissance métallique sur une couche de croissance métallique qui doit être retirée par la suite pour éviter la formation de court-circuit. De telles bosses permettent de décaler verticalement des ports de connexion de composants électroniques dans un même plan de connexion. Il n'existe pas d'interconnexion des composants électroniques entre eux dans le système électronique. On connaît également dans l'art antérieur par la demande de brevet KR 2000 0043575 A un système électronique sur lequel sont déposés des organes métalliques en plusieurs parties pour former une interconnexion. On connait également la demande de brevet JP2006013205 qui présente un composant électronique visant une connexion électrique par l'arrière.

Il existe ainsi un besoin pour former un système électronique comportant une puce électronique formant boîtier et sur laquelle sont montés plusieurs autres composants électroniques de manière optimale.

### PRESENTATION GENERALE DE L'INVENTION

A cet effet, l'invention concerne un système électronique selon la revendication 1.

Avantageusement, un fort amincissement du composant électronique et une planarisation de la surface dudit système ne sont pas nécessaires pour l'intégration et l'interconnexion du système, ce qui permet avantageusement de s'affranchir des problématiques liées à l'amincissement et d'interconnecter une puce ou un empilement de puces de forte épaisseur.

De manière avantageuse, grâce à l'invention, on peut former un système électronique permettant d'intégrer de manière simple et pratique des composants électroniques hétérogènes sur une puce électronique principale formant boitier, sans besoin d'amincir fortement ces composants ni de planariser la surface du système, tout en conservant un encombrement limité. La bille conductrice principale permet avantageusement de connecter la puce principale malgré la présence du composant électronique.

Un tel système électronique, de haute technicité, peut ainsi être monté sur une carte de circuit imprimé d'un téléphone ou autre appareil compact. Le système électronique possède par ailleurs des performances élevées compte tenu des longueurs très courtes des connexions tridimensionnelles entre les composants électroniques tout en ayant un coût réduit. Le système électronique est par ailleurs obtenu avec un nombre limité d'étapes technologiques, ce qui réduit le coût de fabrication. La formation d'interconnexions tridimensionnelles par dépôt métallique permet de réaliser des connexions de qualité de manière rapide et précise. De telles interconnexions offrent une grande flexibilité de réalisation. En outre, un grand nombre de systèmes électroniques peuvent être réalisés de manière simultanée, réduisant davantage le coût.

Grâce à la présente invention, on réalise des interconnexions entre les composants afin de former un système électronique et de bénéficier de synergies, ce qui permet d'améliorer les performances électriques et de réduire le nombre d'entrées/sorties du système et donc le coût de la connexion. Cela est avantageux par comparaison à la demande de brevet CN 103 632 991 B qui enseigne de déporter chaque connecteur des composants et de réaliser les connexions électriques entre les composants par le biais de la carte mère (PCB).

De manière préférée, le plot de connexion est relié à l'interconnexion tridimensionnelle. Ainsi, la bille conductrice principale est reliée au composant électronique et à la puce électronique principale, ce qui permet de former une connexion complexe de manière pratique.

De préférence, le plot de connexion est formé par dépôt métallique de manière simultanée à l'interconnexion tridimensionnelle. Ainsi, le plot de connexion est réalisé de manière rapide à un coût réduit.

Selon un aspect préféré, le composant électronique comprenant au moins deux connecteurs, le système électronique comprend deux interconnexions tridimensionnelles reliées respectivement au premier connecteur du composant électronique et au deuxième connecteur du composant électronique. De manière préférée, les interconnexions sont réalisées au cours d'une même étape technique.

De manière préférée, le système électronique comporte une couche d'encapsulation de manière à encapsuler la surface avant de la puce électronique principale et une portion de la bille conductrice principale. Une telle couche d'encapsulation permet d'améliorer la robustesse mécanique ainsi que la fiabilité, seules les billes conductrices qui doivent être reliées au circuit imprimé sont découvertes, les autres composants électroniques étant protégés. Il va de soi que, pour certaines applications, des composants, tels que des capteurs, peuvent rester découverts.

Selon un aspect préféré, le système électronique comporte une couche métallurgique sous-jacente à la bille conductrice principale, connue sous son appellation anglaise « under-bump metallurgy » (UBM). Une telle couche métallurgique permet d'améliorer la robustesse mécanique et la fiabilité du système.

De manière préférée, le système électronique comporte au moins un empilement vertical de composants électroniques, chaque composant électronique comportant une surface avant comportant au moins un connecteur et une surface arrière opposée à la surface avant, au moins une interconnexion tridimensionnelle reliant au moins un connecteur de chaque composant électronique à un connecteur de la puce électronique principale et/ou à un connecteur d'un autre composant électronique. De préférence, les interconnexions tridimensionnelles sont formées de manière simultanée. Ainsi, un grand nombre de composants électroniques peuvent être ajoutés sur une puce électronique principale afin de former, de manière simple et à faible coût, un système électronique de haute technicité.

De manière préférée, un composant électronique positionné en avant de l'empilement possède des dimensions plus faibles qu'un composant électronique positionné en arrière de l'empilement. De manière avantageuse, les composants électroniques forment un empilement en escalier, ce qui facilite la réalisation de la ou des interconnexions. De manière préférée, les composants électroniques sont de même taille. De préférence encore, les composants électroniques sont reliés par des interconnexions tridimensionnelles en marche d'escaliers, ce qui facilite leur réalisation.

De préférence, le système électronique comporte au moins un composant électronique additionnel comportant une surface avant comportant au moins un connecteur et une surface arrière opposée à la surface avant, la surface avant ou arrière étant positionnée en face de la surface avant de la puce électronique principale, le connecteur du composant électronique additionnel étant relié à ladite interconnexion tridimensionnelle. Ainsi, plusieurs composants électroniques peuvent être connectés directement à une puce électronique principale.

De préférence, le composant électronique additionnel est une puce électronique, un composant monté en surface (CMS) ou un élément inductif. Dans ce dernier cas, l'élément inductif est formé par dépôt métallique simultanément aux interconnexions tridimensionnelles.

Selon un aspect préféré, le système électronique comporte au moins un composant électronique auxiliaire comportant une surface avant comportant au moins un connecteur et une surface arrière opposée à la surface avant, la surface avant ou arrière étant positionnée en face de la surface avant du composant électronique située la plus en avant, le connecteur dudit composant électronique auxiliaire étant relié à ladite interconnexion tridimensionnelle. De préférence, ladite interconnexion tridimensionnelle forme une couche de redistribution tridimensionnelle entre le composant électronique situé le plus en avant et le composant électronique auxiliaire. Ainsi, le composant électronique additionnel peut communiquer avec l'ensemble des composants du système électronique. De préférence encore, le composant électronique auxiliaire est relié aux interconnexions tridimensionnelles par une technique de retournement, dite « flip-chip », par soudure ou par des fils micro-soudés.

De manière préférée, le système électronique comporte au moins une bille conductrice auxiliaire, de dimensions plus faibles que la bille conductrice principale, qui est reliée à l'interconnexion tridimensionnelle, l'ensemble des billes conductrices définissant un unique plan de connexion. Ainsi, on peut augmenter le nombre d'entrées/sorties du système électronique en ajoutant des billes conductrices sur des interconnexions. De préférence, les billes conductrices auxiliaires sont positionnées en avant du composant électronique situé le plus en avant. Ainsi, on augmente la surface de connexion du système électronique.

De manière préférée, l'interconnexion tridimensionnelle forme une couche de redistribution tridimensionnelle supérieure entre la bille conductrice auxiliaire et le composant électronique situé le plus en avant. Une telle couche de redistribution tridimensionnelle supérieure permet de relier la bille conductrice auxiliaire aux autres composants du système électronique de manière pratique en limitant la longueur des connexions.

Selon un aspect préféré, le système électronique comporte une couche de redistribution inférieure formée entre le composant électronique situé le plus en arrière et la puce électronique principale formant boitier. Une telle couche de redistribution inférieure permet d'augmenter la densité d'intégration et de faciliter le routage des connexions et le positionnement des billes conductrices afin de répondre aux besoins de systèmes électroniques de haute densité.

De préférence, l'interconnexion tridimensionnelle présente un rapport de forme, largeur sur hauteur, inférieur à 1 :1.5, de préférence, inférieur à 1 :3. Par exemple, pour une interconnexion tridimensionnelle qui a une largeur de 40µm et qui monte sur un composant qui a une hauteur de 300µm, son rapport de forme est de 1 :7.5, alors que pour une autre interconnexion tridimensionnelle qui a une largeur de 15µm et qui monte sur une puce qui a une hauteur de 150µm, son rapport de forme est de 1 :10. Une telle interconnexion fine permet de connecter de manière pratique deux composants écartés verticalement d'une hauteur importante tout en ayant une largeur réduite, ce qui autorise une haute densité de connexions et d'intégration du système.

De manière préférée, le système électronique comporte au moins un élément passif formé de manière simultanée à l'interconnexion tridimensionnelle. Ainsi, l'interconnexion tridimensionnelle remplit une fonction de connexion mais également une fonction passive par formation d'éléments passifs (inductances, résistance, etc.).

De manière préférée, le système électronique comporte au moins un écarteur disposé entre la bille conductrice principale et la puce électronique principale formant boitier de manière à augmenter la distance entre le plan de connexion et la surface avant de la puce électronique principale. Ainsi, un grand nombre de composants et/ou des composants de grande hauteur peuvent être avantageusement empilés et/ou montés sur la puce électronique principale.

L'invention concerne également une méthode de mise en place d'un système électronique selon l'une des réalisations précédentes sur une carte de circuit imprimé, méthode dans laquelle la bille conductrice principale du système électronique est fixée sur la carte de circuit imprimé par une technique de retournement dite « flip-chip ».

De manière préférée, une couche de remplissage est disposée entre le système électronique et la carte de circuit imprimé de manière à améliorer la robustesse et la fiabilité du système électronique.

L'invention concerne en outre une carte électronique comprenant un circuit imprimé et un système électronique tel que présenté précédemment dont la bille conductrice principale est solidarisées au circuit imprimé.

L'invention vise également un procédé de fabrication d'un système électronique tel que présenté précédemment, comprenant :
- une étape de mise à disposition d'une galette comportant une pluralité de puces électroniques principales, chaque puce électronique principale comportant une surface avant comportant au moins un connecteur et une surface arrière opposée à la surface avant,selon la revendication 5.

Grâce à l'invention, on réalise de manière pratique et peu onéreuse un système électronique comportant des composants électroniques hétérogènes en s'appuyant sur les interconnexions tridimensionnelles. On tire ainsi avantageusement partie de la dimension verticale pour augmenter la densité d'intégration.

De préférence, l'étape de réalisation d'une interconnexion tridimensionnelle comporte :
- une étape de dépôt d'une couche métallique d'accrochage
- une étape de dépôt d'une couche de résine épaisse et une étape de réalisation d'ouvertures définissant la forme des interconnexions tridimensionnelles
- une étape de dépôt d'une couche de métal, et
- une étape de dissolution de la couche de résine et une étape de gravure de la couche métallique d'accrochage.

### PRESENTATION DES FIGURES

L'invention sera mieux comprise à la lecture de la description qui va suivre, donnée uniquement à titre d'exemple, et se référant aux dessins annexés sur lesquels :
- la figure 1 est une représentation schématique d'une première forme de réalisation d'un système selon l'invention ;
- la figure 2 est une représentation schématique du système de la figure 1 en position montée sur un circuit imprimé ;
- la figure 3 est une représentation schématique du système de la figure 1 en position montée sur un circuit imprimé avec une couche de remplissage ;
- la figure 4 est une représentation schématique d'une deuxième forme de réalisation d'un système selon l'invention avec une couche d'encapsulation ;
- les figures 5a-5g sont des représentations schématiques de la fabrication de deux systèmes ;
- la figure 6 est une représentation schématique d'une troisième forme de réalisation d'un système selon l'invention ;
- la figure 7 est une représentation schématique d'une quatrième forme de réalisation d'un système selon l'invention ;
- la figure 8 est une représentation schématique d'une cinquième forme de réalisation d'un système selon l'invention ;
- les figures 9-13 sont des représentations schématiques de circuits imprimés comportant un système électronique selon l'invention ;
- la figure 14 est une représentation schématique d'une sixième forme de réalisation d'un système selon l'invention ;
- la figure 15 est une représentation schématique d'une septième forme de réalisation d'un système selon l'invention ;
- la figure 16 est une représentation schématique d'une huitième forme de réalisation d'un système selon l'invention ;
- la figure 17 est une représentation schématique d'une neuvième forme de réalisation d'un système selon l'invention ; et
- la figure 18 est une représentation schématique du montage du système de la figure 17.

Il faut noter que les figures exposent l'invention de manière détaillée pour mettre en œuvre l'invention, lesdites figures pouvant bien entendu servir à mieux définir l'invention le cas échéant.

### DESCRIPTION D'UN OU PLUSIEURS MODES DE REALISATION ET DE MISE EN OEUVRE

Il va être présenté un système électronique comportant une pluralité de composants électroniques apte à être monté sur un circuit imprimé afin de former une carte électronique. Une telle carte électronique peut être montée dans toute sorte d'appareils électroniques, par exemple, un ordinateur, une montre, un téléphone intelligent, un objet connecté, un vêtement, un équipement portable, etc.

### Forme de réalisation n°1

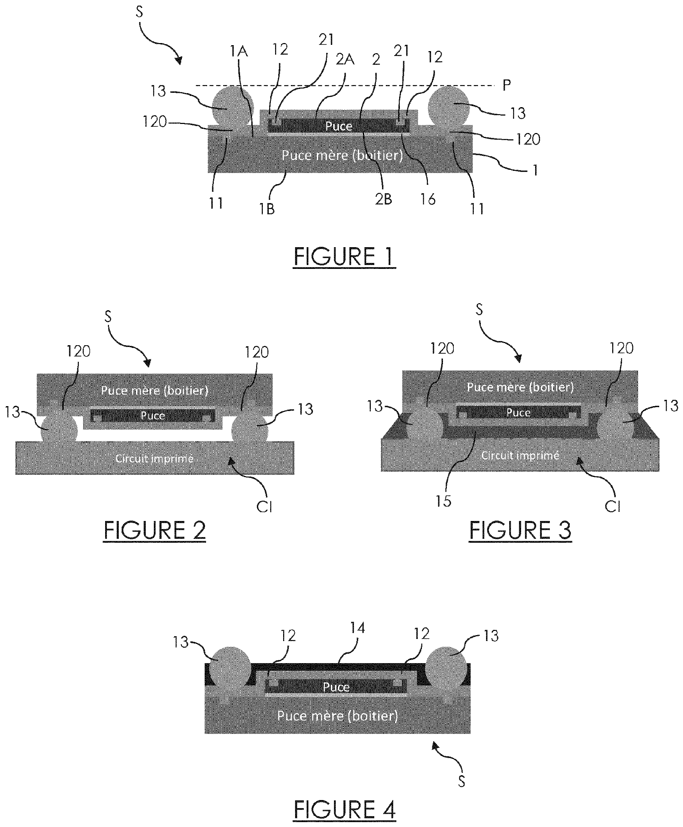

En référence à la figure 1, il est représenté un système électronique S selon une première forme de réalisation.

Le système électronique S comporte une puce électronique principale 1 formant boitier. Autrement dit, la puce électronique principale 1 forme un « package » comme cela est connu de l'homme du métier. La puce électronique principale 1 n'est ainsi pas protégée dans un boitier rapporté mais est apte à être directement solidarisée à un circuit imprimé CI comme cela sera présenté par la suite.

Comme illustré à la figure 1, la puce électronique principale 1 se présente sous la forme d'un corps aplati, de préférence un pavé, comportant une surface avant 1A comportant deux connecteurs 11 et une surface arrière 1B opposée à la surface avant 1A. Dans cet exemple, la surface arrière 1B forme la surface extérieure du système électronique S après solidarisation à un circuit imprimé CI. Il va de soi que le nombre de connecteurs 11 pourrait être différent.

Le système électronique S comporte en outre deux plots de connexion 120 reliés à la surface avant 1A de ladite puce électronique principale 1 et deux billes conductrices principales 13 solidarisées auxdits plots de connexion 120 et adaptées pour se connecter à un circuit imprimé CI. De telles billes conductrices principales 13 sont connues de l'homme du métier sous leur désignation anglaise « micro-bump » et ne seront pas présentées en détails.

Toujours en référence à la figure 1, le système électronique S comporte un composant électronique 2 comportant une surface avant 2A comportant deux connecteurs 21 et une surface arrière 2B opposée à la surface avant 2A. Dans cet exemple, le composant électronique 2 est une puce électronique. Par souci de clarté, afin de différencier le composant électronique 2 de la puce électronique principale 1, le composant électronique 2 sera désigné « puce électronique fille ». Il va de soi que le composant électronique pourrait se présenter sous des formes diverses, notamment, composant monté en surface, inductance, etc.

La surface arrière 2B de la puce électronique fille 2 est positionnée face à la surface avant 1A de la puce électronique principale 1 de manière à ce que la puce électronique fille 2 soit en saillie de la surface avant 1A de la puce électronique principale 1. Il va de soi que le nombre de connecteurs 21 pourrait être différent.

La puce électronique fille 2 possède des dimensions plus faibles que la puce électronique principale 1 de manière à ce que les connecteurs 11 de la puce électronique principale 1 soient dégagés, c'est-à-dire, non recouvertes par la puce électronique fille 2. Dans cet exemple, la surface arrière 2B de la puce électronique fille 2 est directement solidarisée à la surface avant 1A de la puce électronique principale 1 comme illustré à la figure 1.

Dans cet exemple, le système électronique S comporte une unique puce électronique fille 2 mais il va de soi qu'il pourrait comprendre plusieurs composants électroniques solidarisés ensemble à la surface avant 1A de la puce électronique principale 1. On peut ainsi former un système électronique S de grande technicité.

Dans cet exemple, au moins une interconnexion tridimensionnelle 12 réalisée par dépôt métallique relie le connecteur de la puce électronique fille 2 à un plot de connexion 120 et au connecteur 11 de la puce électronique principale 1, le plot de connexion 120 étant formé par dépôt métallique de manière simultanée à l'interconnexion tridimensionnelle 12. Le nombre de connecteurs 11, 21 reliés entre eux dépend du degré d'interaction entre les deux puces électroniques 1, 2 dans le système électronique S.

Dans l'exemple de la figure 1, le système électronique S comporte deux interconnexions tridimensionnelles 12 qui sont identiques mais il va de soi qu'elles pourraient être différentes. Chaque interconnexion tridimensionnelle 12 est reliée simultanément à un connecteur de la puce électronique fille 2, à un plot de connexion 120 et à un connecteur 11 de la puce électronique principale 1.

Au lieu de connecter directement les plots de connexion 120 de la puce électronique principale 1 à un circuit imprimé CI, on utilise des billes conductrices principales 13 d'épaisseurs plus importantes de manière à ménager de l'espace en avant de la surface avant 1A de la puce électronique principale 1 afin de solidariser (au moins) une puce électronique fille 2 ou un autre composant électronique. Selon l'invention, les billes conductrices principales 13 s'étendent en avant de la surface avant du composant électronique situé le plus en avant.

Ainsi, on obtient un système électronique S de grande technicité et de faible encombrement en utilisant de manière astucieuse une puce électronique principale 1 formant boîtier. En référence à la figure 1, les billes conductrices principales 13 définissent un plan de connexion P s'étendant parallèlement à la surface avant 1A de la puce électronique principale 1.

En référence à la figure 2, on obtient ainsi un système électronique S qui peut être solidarisé à un circuit imprimé CI par différentes techniques, en particulier, une technique de solidarisation par retournement, connue de l'homme du métier sous sa dénomination anglaise « flip-chip ». Comme illustré à la figure 2, les billes conductrices principales 13 du système électronique S sont solidarisées à des pistes conductrices du circuit imprimé CI.

De manière préférée, en référence à la figure 3, après solidarisation du système électronique S au circuit imprimé CI, il est injecté un matériau de remplissage 15, connu de l'homme du métier sous sa désignation anglaise « underfill » afin d'améliorer la robustesse mécanique du système électronique S. Un tel matériau de remplissage 15 comporte, par exemple, un polymère tel que l'époxy ou l'acrylate et qui peut être chargé par des particules de silice, d'alumine, de carbone, ou autres afin d'ajuster ses propriétés mécaniques tels que sont coefficient de dilatation thermique, son module de Young ou autres.

### Méthode de fabrication

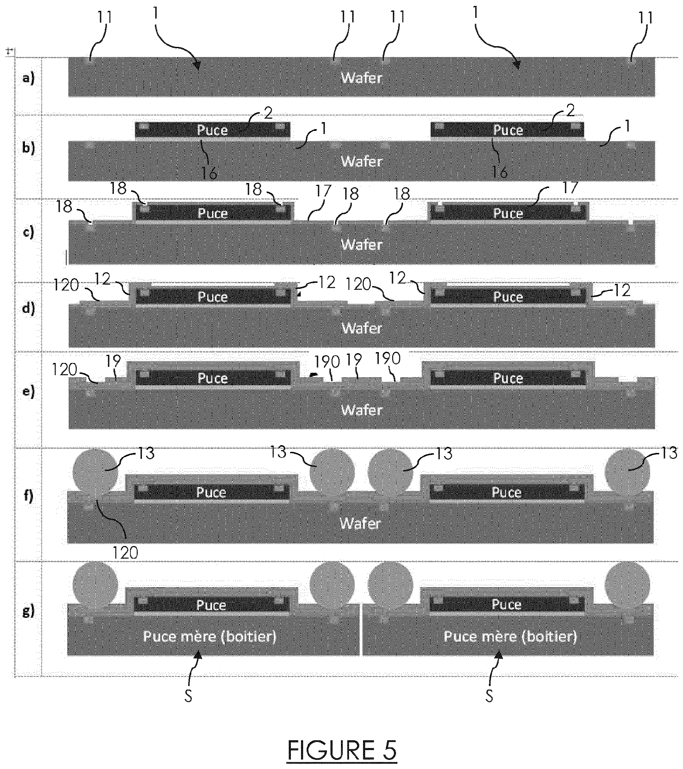

Un exemple de fabrication va être présenté en référence à la figure 5 illustrant plusieurs étapes techniques de fabrication.

En référence à la figure 5a, il est représenté une galette, connue de l'homme du métier sous la désignation anglaise « wafer » ou « panel », comportant des puces électroniques principales 1 aptes à former un boitier. La galette peut être en matériau semiconducteur tels que le silicium, le germanium, l'arséniure de galium, le carbure de silicium ainsi qu'en verre, en polymère ou autres matériaux rigides et/ou flexibles. La galette peut également comprendre des composants passifs.

Dans cet exemple, il est représenté deux puces électroniques principales 1. Chaque puce électronique principale 1 comporte une surface avant 1A comportant deux connecteurs 11 et une surface arrière 1B opposée à la surface avant 1A.

En référence à la figure 5B, des puces électroniques filles 2 sont reportées sur les puces électroniques principales 1 par une technique connue de l'homme du métier, par exemple, la technique de report connue de l'homme du métier sous la désignation anglaise « pick and place ». Dans cet exemple, une couche de colle 16 est déposée entre la surface arrière 2B de chaque puce électronique fille 2 et la surface avant 1A de la puce électronique fille 2. De manière analogue, lorsque plusieurs puces électroniques filles 2 sont empilées verticalement, elles sont de préférence solidarisées ensemble par collage.

De manière préférée, l'épaisseur verticale totale (puce(s) fille(s) 2 et couche(s) de colle 16) est supérieure à 10µm, plus particulièrement, supérieure à 30 µm, 40 µm et 50 µm. Les flancs des puces électroniques filles 2 peuvent être droits, en dépouille et/ou en contre dépouille. Par souci de clarté, seules des puces électroniques filles 2 ayant des flancs droits ont été utilisées sur les figures.

En référence à la figure 5c, une couche de passivation 17 est ensuite appliquée sur l'ensemble de manière à passiver, c'est-à-dire à rendre isolants, les surfaces exposées des puces électroniques 1,2. Selon le besoin du système, une telle couche de passivation 17 est déposée d'une manière conforme ou d'une manière à adapter l'angle des flancs des puces électroniques 2 sans qu'elle remplisse une fonction de planarisation de la surface du système. La couche de passivation 17 peut être composée d'un matériau organique ou inorganique, tel qu'un oxyde de semi-conducteur, un oxyde de métal, un polymère ou tous autres matériaux électriquement isolants. Elle peut être déposée par enduction centrifuge, par spray, par lamination, par pressage, par croissance, par impression (inkjet), par dépôt sous vide ou par tout type de dépôt connu par l'homme du métier. Toujours en référence à la figure 5c, des ouvertures 18 sont par la suite réalisées dans la couche de passivation 17, afin de découvrir les connecteurs 11, 21 des puces électroniques 1,2, à l'aide d'un procédé de photolithographie ou à l'aide d'une gravure par voie chimique humide et/ou sèche, par plasma ou par laser. De manière préférée, des matériaux photosensibles sont privilégiés compte tenu des avantages offerts par les procédés de photolithographie.

Dans le cas où les surfaces et les flancs des puces électroniques 1, 2 sont isolants sauf au niveau des connecteurs 11, 21, le dépôt de la couche de passivation 17 peut ne pas être appliqué, réduisant ainsi le temps et le coût de fabrication.

Ensuite, en référence à la figure 5d, des interconnexions tridimensionnelles 12 ainsi que des plots de connexion 120 sont formés pour interconnecter les connecteurs 11, 21 des puces électroniques 11, 21. Les interconnexions tridimensionnelles 12 sont connues en soi, en particulier, par la demande de brevet FR2965659. Dans cet exemple, pour réaliser les interconnexions tridimensionnelles 12 et les plots de connexion 120, le procédé comporte :
- une étape de dépôt d'une couche métallique par évaporation, par pulvérisation ou autre, qui remplit à la fois une fonction de base d'accrochage et de croissance du métal constituant les interconnexions tridimensionnelles 12 et les plots de connexion 120. Cette couche métallique peut être composée d'un unique ou de plusieurs matériaux conducteurs de l'électricité et/ou semiconducteurs.
- une étape de dépôt d'une couche épaisse de résine photosensible et une étape de réalisations d'ouvertures par des techniques de photolithographie, par ablation laser ou autres, afin de créer un moule nécessaire au dépôt du métal constituant les interconnexions tridimensionnelles 12. Ces ouvertures définissent la forme des interconnexions tridimensionnelles 12 ainsi que celles des pistes métalliques formant la couche de redistribution tridimensionnelle (présentée par la suite) et les plots de connexion 120. Selon le besoin d'intégration, l'épaisseur de la couche de résine photosensible peut varier de 40 à 700µm et le rapport de forme (résolution) de 0.5 :1 à 50 :1.
- une étape de dépôt d'une couche de métal par électrolyse ou toute autre technique de croissance de métal. Le métal déposé peut être du cuivre, de l'or, de l'argent, du nickel, un alliage de métaux ou tout autre matériau conducteur de l'électricité.
- une étape de dissolution du moule de résine et une étape de gravure de la couche d'accrochage. Ces procédés sont connus par l'homme du métier. Cependant, dans le cas où la coche d'accrochage contient de l'or, une solution à base de Kl+I2 et d'additifs pourrait être utilisée pour graver cette couche sans abimer les interconnexions tridimensionnelles 12.

Les interconnexions tridimensionnelles 12 étant créées, en référence dorénavant à la figure 5e, le procédé comporte une étape de dépôt d'une deuxième couche de passivation 19. La figure 5e illustre une couche de passivation 19 conforme, c'est-à-dire, la différence entre son épaisseur sur les faces et sur les flancs des puces électroniques 1,2 varie de ±30%. Cependant, le dépôt de cette couche de passivation 19 pourrait ne pas être conforme où être omis en fonction des besoins. Des ouvertures 190 sont formées dans la deuxième couche de passivation 19 de manière à permettre un accès aux plots de connexion 120 formés avec les interconnexions tridimensionnelles 12.

En référence à la figure 5f, le procédé comporte une étape de dépôt des billes conductrices principales 13 dans les ouvertures 190 de la deuxième couche de passivation 19 de manière à se connecter électriquement aux plots de connexion 120. On obtient ainsi une pluralité de systèmes électroniques S sur une même galette.

Enfin, en référence à la figure 5g, la galette est découpée de manière à séparer les systèmes électroniques S afin de pouvoir les utiliser de manière individuelle. De manière optionnelle, la galette peut être amincie afin de diminuer l'encombrement du système électronique S.

### Forme de réalisation n°2

Une autre forme de réalisation d'un système électronique S selon l'invention est représentée à la figure 4. Par souci de clarté et de concision, les éléments identiques ou analogues entre les autres formes de réalisation sont référencés avec la même référence numérique, seules les différences entre les formes de réalisation sont présentées en détails.

En référence à la figure 4, le système électronique S comporte une couche d'encapsulation 14 de manière à encapsuler la surface avant du système électronique S et une portion des billes conductrices principales 13. De manière préférée, la couche d'encapsulation 14 est réalisée en polymère, par exemple en époxy, et chargé ou non de particules telles que de la silice, de l'alumine, etc. mais il va de soi que d'autres matériaux analogues pourraient convenir. Une telle couche d'encapsulation 14 permet avantageusement d'améliorer la robustesse mécanique ainsi que la fiabilité du système électronique S. Une telle couche d'encapsulation 14 peut avantageusement être appliquée à toutes les formes de réalisation du système électronique S.

De préférence, la couche d'encapsulation 14 est déposée suite au dépôt des billes conductrices 13. Une telle étape est avantageuse car elle s'intègre facilement au procédé de fabrication du système électronique S.

De manière alternative, les billes conductrices principales 13 peuvent être déposées après le dépôt de la couche d'encapsulation 14, il est alors nécessaire de réaliser des ouvertures dans la couche d'encapsulation 14 de manière à accéder aux plots de connexion 120.

### Forme de réalisation n°3

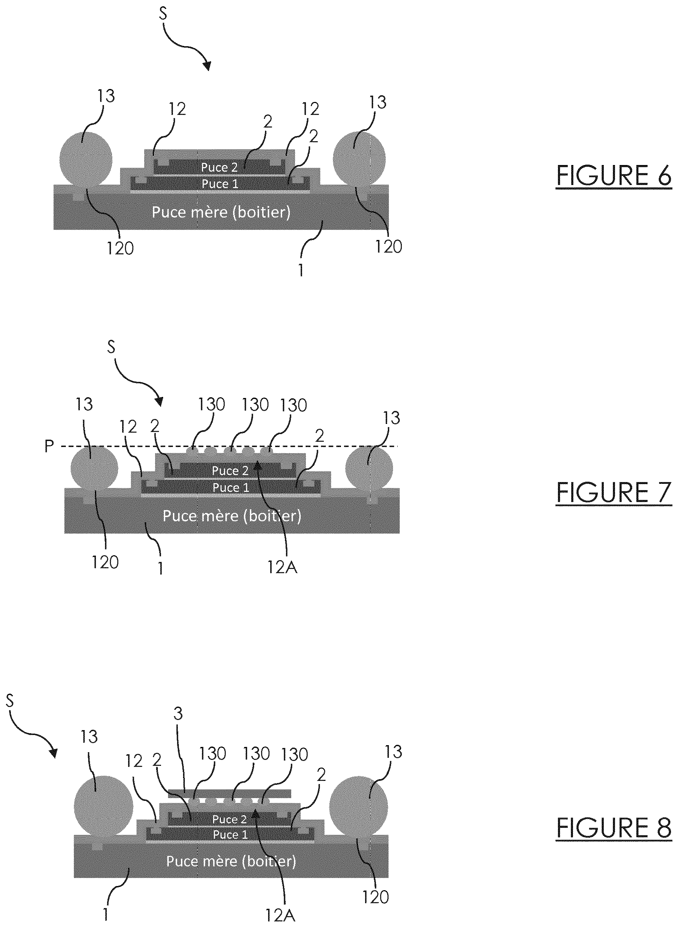

Une autre forme de réalisation d'un système électronique S selon l'invention est représentée à la figure 6. Par souci de clarté et de concision, les éléments identiques ou analogues entre les autres formes de réalisation sont référencés avec la même référence numérique, seules les différences entre les formes de réalisation sont présentées en détails.

Dans cet exemple, le système électronique S comporte plusieurs puces électroniques filles 2 assemblées verticalement pour former un empilement. Chaque puce électronique fille 2 comporte une surface avant 2A comportant au moins deux connecteurs 21 et une surface arrière 2B opposée à la surface avant 2A. Les puces électroniques 2 possèdent la même orientation dans l'empilement, la surface arrière d'une puce « avant » étant en face de la surface avant d'une puce « arrière ». La puce électronique fille 2 la plus en arrière de l'empilement est montée sur la surface avant 1A de la puce électronique principale 1.

Dans cette forme de réalisation, en référence à la figure 6, le système électronique S comporte un empilement vertical de deux puces électroniques filles afin de former un système de haute technicité. Il va de soi que le système électronique S pourrait comprendre un empilement d'un grand nombre de composants électroniques de natures différentes.

Dans cet exemple, les plots de connexion 120, les connecteurs 11 de la puce électronique principale 1 et les connecteurs 21 de chaque puce électroniques fille 2 sont respectivement reliés entre eux à l'aide d'interconnexions tridimensionnelles 12 réalisées par dépôt métallique. Les plots de connexion 120 sont formés simultanément avec lesdites interconnexions tridimensionnelles 12. De manière avantageuse, même en cas de pluralité de puces électroniques filles 2, les interconnexions tridimensionnelles 12 sont réalisées au cours d'une seule et même étape.

En fonction de la complexité, les étapes de dépôt des couches de passivation 17 et de dépôt des interconnexions tridimensionnelles 12 peuvent être répétées pour répondre au besoin d'intégration de systèmes à haute densité.

De manière préférée, chaque puce électronique fille 2 située en avant d'un empilement possède des dimensions inférieures à une puce électronique fille 2 située en arrière dudit empilement de manière à former un empilement facilitant la formation d'interconnexion tridimensionnelles 12 entre les différentes puces électroniques filles 2. La compacité et la densité d'intégration est ainsi augmentée de manière simple.

De manière préférée, l'empilement est pyramidal (Figure 6) ou en marche d'escaliers. Selon ce dernier cas, il est possible d'empiler des puces électroniques filles 2 ayant une taille identique ou bien des puces électroniques filles 2 de taille plus grande par-dessus de puces électroniques filles 2 de taille plus petite. Il va de soi que les puces électroniques filles 2 peuvent avoir des dimensions différentes.

### Forme de réalisation n°4

De manière préférée, en référence à la figure 7, le système électronique S peut comprendre des billes conductrices auxiliaires 130 positionnées en avant de la surface avant de la puce électronique fille 2 la plus en avant. Dans cet exemple, en référence à la figure 7 représentant un système électronique S comportant un empilement de deux puces électroniques filles 2, des billes conductrices auxiliaires 130 sont positionnées sur la surface avant 2A de la puce électronique fille 2 la plus en avant. De manière préférée, les billes conductrices principales 13 et les billes conductrices auxiliaires 130 appartiennent à un même plan de connexion P de manière à permettre une solidarisation du système électronique S par une technique de retournement, c'est à dire, par une méthode de « flip-chip ».

De manière préférée, les billes conductrices auxiliaires 130 sont reliées aux interconnexions tridimensionnelles 12. De manière préférée, les interconnexions tridimensionnelles 12 forment une couche de redistribution tridimensionnelle supérieure 12A entre la surface avant 2A de la puce électronique fille 2 la plus en avant et les billes conductrices auxiliaires 130. Une telle couche de redistribution tridimensionnelle supérieure 12A permet de disposer de manière flexible les billes conductrices auxiliaires 130 pour augmenter le nombre d'entrées/sorties du système électronique S.

Lorsque le système électronique S comporte une couche de redistribution (supérieure, inférieure ou latérale comme cela sera présenté par la suite), une couche de passivation est préalablement déposée sur la surface supérieure de l'empilement. De préférence, cette couche de passivation comporte des flancs inclinés de manière à permettre le dépôt métallique. Les flancs sont réalisés de préférence par formation d'ouvertures dans la couche de passivation. En fonction de la complexité, plusieurs dépôts de couches de passivation et plusieurs dépôts métalliques peuvent être réalisés.

Ainsi, malgré l'empilement des puces électroniques filles 2 sur la puce électronique principale 1, les billes conductrices auxiliaires 130 sont déportées de manière pratique sur le surface avant du système électronique S, ce qui garantit une connexion aisée aux connecteurs 11, 21 des puces électroniques 1, 2.

### Forme de réalisation n°5

Selon une autre forme de réalisation, en référence à la figure 8, le système électronique S peut comporter un composant électronique auxiliaire 3, comportant une surface avant comportant des connecteurs et une surface arrière opposée, qui est montée en avant de la puce électronique fille 2 la plus en avant.

En référence à la figure 8, la couche de redistribution tridimensionnelle supérieure 12A des interconnexions tridimensionnelles 12 permet de connecter de manière pratique le composant électronique auxiliaire 3 aux puces électroniques 1, 2, en particulier par retournement « flip-chip » (Figure 8) ou par liaisons microsoudées.

Une telle méthode de fabrication est adaptée pour assembler, dans un premier temps, un ensemble de puces électroniques déterminées tout en permettant l'ajout d'un composant électronique auxiliaire 3, dans un deuxième temps, en fonction des besoins. On réalise ainsi de manière flexible et pratique un système électronique S. Une telle méthode de fabrication permet en outre d'intégrer un composant électronique auxiliaire 3 qui ne pourrait pas être intégré à l'empilement de puces électroniques filles 2. Autrement dit, on tire avantage de l'épaisseur verticale du système électronique S pour intégrer un empilement de puces 2 et un composant électronique auxiliaire 3. Le composant électronique auxiliaire 3 est situé en arrière du plan de connexion P de manière à permettre une solidarisation du système électronique S à un circuit imprimé CI.

### Variété de systèmes électroniques

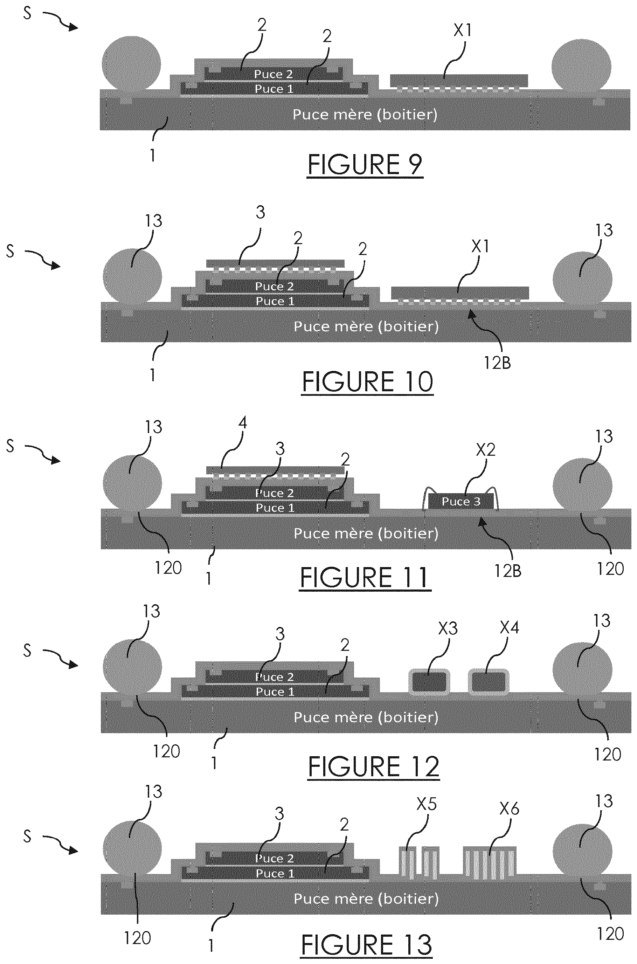

En référence aux figures 9 à 13, il est représenté plusieurs exemples de systèmes électroniques S selon l'invention.

En référence à la figure 9, le système électronique S comporte une puce électronique principale formant boîtier 1 sur laquelle sont montés : un empilement de puces électroniques 2 et un composant électronique additionnel X1 positionné en avant de la surface avant 1A de la puce formant boîtier de manière à loger le composant électronique additionnel X1 à côté de l'empilement de puces électroniques filles 2.

A cet effet, en référence à la figure 9, les interconnexions tridimensionnelles 12 définissent une couche de redistribution tridimensionnelle latérale 12B, c'est-à-dire à côté de l'empilement de puces électroniques filles 2, afin de pouvoir connecter le composant électronique additionnel X1 aux autres puces électroniques 1, 2 sans augmenter l'épaisseur verticale du système électronique S. Le composant électronique auxiliaire X1 peut être relié par tout moyen, par exemple, par une technique de retournement (Figure 9).

En référence à la figure 10, outre le composant électronique additionnel X1 monté à côté de l'empilement de puces électroniques filles 2 de manière similaire à la figure 9, le système électronique S comporte un composant électronique auxiliaire 3 monté sur l'empilement des puces électroniques filles 2 par le biais d'une couche de redistribution supérieure 12A. Un tel montage a été présenté en référence à la figure 8 et ne sera pas présenté de nouveau en détails.

En référence à la figure 11, en lieu et place d'un composant électronique additionnel 11 monté par une technique de retournement à côté de l'empilement de puces électroniques 2, le système électronique S comporte un composant électronique additionnel 11 monté par des fils micro-soudés à la couche de redistribution supérieure 12A.

En référence à la figure 12, en lieu et place d'un composant électronique additionnel X1 montée à côté de l'empilement de puces électroniques filles 2, le système électronique S comporte un ou plusieurs composants X3, X4 du type « Composé Monté en Surface ».

En référence à la figure 13, en lieu et place d'un composant électronique additionnel X1 montée à côté de l'empilement de puces électroniques filles 2, le système électronique S comporte un ou plusieurs éléments inductifs X5, X6 qui sont, de préférence, réalisés simultanément aux interconnexions tridimensionnelles 12. Autrement dit, le système électronique S comporte des éléments passifs formés de manière simultanée à l'interconnexion tridimensionnelle.

### Forme de réalisation n°6

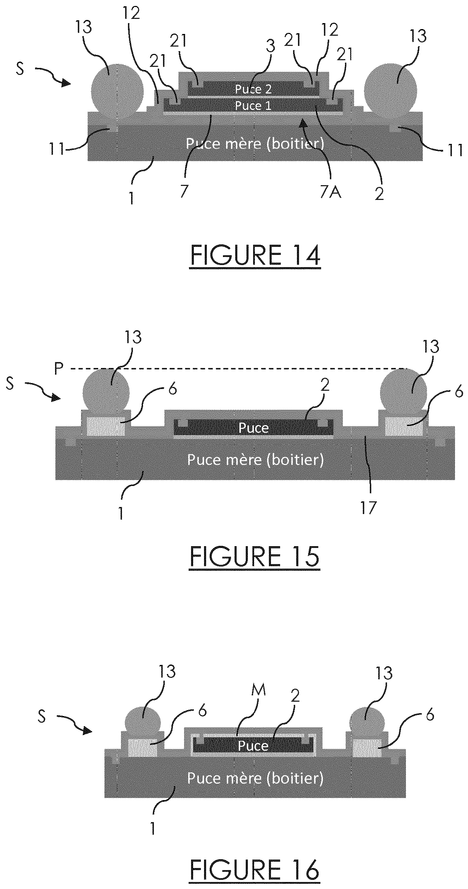

Dans la forme de réalisation de la figure 14, le système électronique S comporte entre la puce électronique principale 1 formant boitier et un empilement de puces électroniques filles 2, des interconnexions planaires préliminaires 7 définissant une couche de redistribution planaire inférieure 7A de manière à améliorer le routage entre la puce électronique principale 1 et l'empilement de puces électroniques filles 2, en particulier, en cas de forte densité de connecteurs.

Les interconnexions planaires préliminaires 7 sont formées préalablement aux interconnexions tridimensionnelles 12 et avant le dépôt de puces électroniques filles 2 de l'empilement. Dans cet exemple, les interconnexions planaires préliminaires 7 sont reliées aux connecteurs 11 de la puce électronique principale 1 et forment la couche de redistribution planaire inférieure 7A. Les interconnexions tridimensionnelles 12 relient les interconnexions préliminaires 7 aux connecteurs 21 des puces électroniques filles 2. Autrement dit, la couche de redistribution planaire inférieure 7A est réalisée directement sur la galette comportant les puces électroniques principales 1.

### Forme de réalisation n°7

Dans la forme de réalisation de la figure 15, afin de régler l'épaisseur du système électronique S, le système électronique S comporte des écarteurs 6, isolants ou isolés, disposés entre au moins une bille conductrice principale 13 et la puce électronique principale 1 formant boitier. Un tel écarteur 6 permet d'écarter le plan de connexion P du système électronique S de la surface avant de la puce électronique principale 1 formant boitier. Une telle conception est adaptée lorsqu'un espace de grande hauteur est désiré pour ajouter les composants. Ainsi, le système électronique S peut toujours être monté par retournement sur un circuit imprimé CI.

La forme des écarteurs 6 dépend des besoins de l'application. Elle peut être rectangulaire, circulaire, sphérique, parabolique, etc. sans que ceci ait une incidence sur le procédé technologique. De manière préférée, les écarteurs 6 sont formés à l'aide d'une technique de photolithographie, d'injection ou autre. Les écarteurs 6 peuvent de plus être réalisés à l'aide de report de structures isolantes et/ou isolées, de la même façon qu'une puce ou qu'un composant est reporté sur un substrat (technique de report de puces/composants).

A titre de variante, en référence à la figure 16, lors de la formation des écarteurs 6 par dépôt d'un matériau isolant ou isolé, une couche de matériau isolant ou isolé M peut être également déposée sur la puce électronique fille 2. Une telle forme de réalisation permet avantageusement d'omettre l'étape de dépôt d'une couche de passivation avant de former les interconnexions tridimensionnelles 12.

De manière analogue, la ou les puces électroniques filles 2 peuvent être passivées préalablement à leur report sur la puce électronique principale 1 afin de bénéficier des avantages susmentionnés.

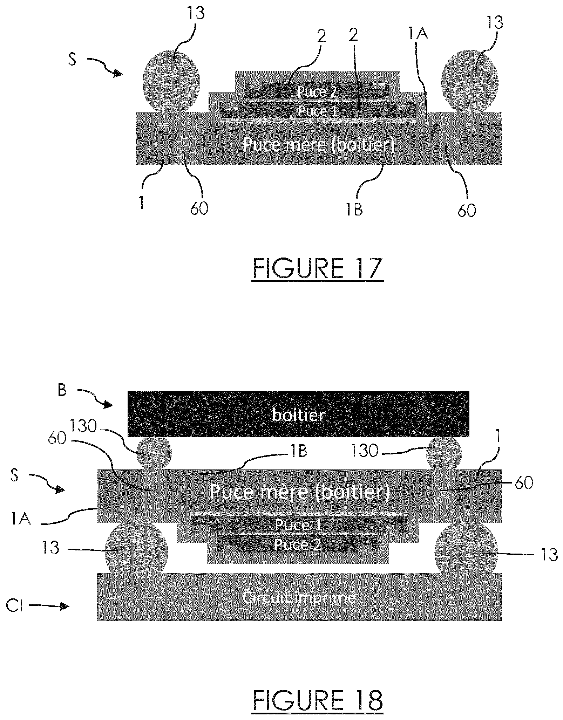

Selon un autre aspect de l'invention, en référence aux figues 17 et 18, la puce principale 1 comporte des vias traversants 60 et rejoignant sa surface avant 1A à sa surface arrière 1B et permettant le montage d'un boitier auxiliaire B. Aussi, le système électronique S peut avantageusement remplir une fonction d'interposeur. Dans cet exemple, en référence à la figure 18, le système électronique S comporte des billes de connexion 130 reliées à la surface arrière 1B de la puce principale 1 qui sont reliées aux vias 60.

### Conclusion

Grâce à l'invention, on peut réaliser des systèmes électroniques, à l'échelle d'une puce, permettant une intégration hétérogène et tridimensionnelle. Ce type d'intégration permet une forte miniaturisation ainsi qu'une amélioration des performances des systèmes sans utiliser des technologies complexes telles que celle des vias traversants.

De manière avantageuse, la méthode de fabrication est effectuée à l'échelle d'une galette et ne nécessite qu'un faible nombre d'étapes technologiques permettant de réaliser plusieurs systèmes électroniques S simultanément, ce qui réduit le temps et le coût de fabrication.

Ce procédé permet une grande flexibilité de conception. Par ailleurs, la topologie de la puce électronique principale 1 formant boitier peut être optimisée pour améliorer les performances électriques et thermiques et pour répondre aux besoins d'applications ayant un grand nombre d'entrées/sorties et/ou intégrant des capteurs. L'intégration tridimensionnelle, par utilisation d'une même couche de métallisation ou en intégrant plusieurs couches de métal, permet d'obtenir une miniaturisation optimale sans dégrader les fonctions.

Les différents exemples de réalisation ont été décrits pour des composants électroniques se présentant sous la forme de puces électroniques. Néanmoins, il est rappelé que d'autres types de composants électroniques pourraient convenir.

## Revendications

1. Système électronique (S) comportant :
- une puce électronique principale (1) formant boitier, ladite puce électronique principale (1) comportant une surface avant (1A) comportant une pluralité de connecteurs (11) et une surface arrière (1B) opposée à la surface avant (1A) ;
- au moins un composant électronique (2) comportant une surface avant (2A) comportant une pluralité de connecteurs (21) et une surface arrière (2B) opposée à la surface avant (2A) ;
- la surface arrière (2B) du composant électronique (2) étant positionnée face à la surface avant (1A) de la puce électronique principale (1) de manière à ce que le composant électronique (2) soit en saillie verticale de la surface avant (1A) de la puce électronique principale (1) ;
- une pluralité d'interconnexions tridimensionnelles indépendantes réalisées par dépôt métallique reliant un connecteur (21) du composant électronique (2) à un connecteur (11) de la puce électronique principale (1), au moins interconnexion tridimensionnelle présentant un rapport de forme, largeur sur hauteur, inférieur à 1 :1.5
**le système** étant **caractérisé en ce que**
- pour chaque interconnexion indépendante, au moins un plot de connexion (120) relié à la surface avant (1A) de ladite puce électronique principale (1) et formé par dépôt métallique de manière simultanée à l'interconnexion tridimensionnelle.et
- pour chaque interconnexion indépendante, au moins une bille conductrice principale (13) solidarisée directement audit plot de connexion et adaptée pour se connecter à un circuit imprimé (CI), la bille conductrice principale (13) s'étendant en avant de la surface avant (2A) du composant électronique (2).

2. Système électronique (S) selon la revendication précédente, dans lequel le système électronique (S) comporte une couche d'encapsulation (14) de manière à encapsuler la surface avant (1A) de la puce électronique principale (1) et une portion de la bille conductrice principale (13).

3. Système électronique (S) selon l'une des revendications 1 à 2, dans lequel le système électronique (S) comporte au moins une bille conductrice auxiliaire (130), de dimensions plus faibles que la bille conductrice principale (13), qui est reliée à l'interconnexion tridimensionnelle (12), l'ensemble des billes conductrices (13, 130) définissant un unique plan de connexion (P).

4. Système électronique (S) selon l'une des revendications 1 à 3, dans lequel au moins une interconnexion tridimensionnelle présente un rapport de forme, largeur sur hauteur, inférieur à 1:3.

5. Procédé de fabrication d'un système électronique (S) selon l'une des revendications 1 à 4, comprenant :
- une étape de mise à disposition d'une galette comportant une pluralité de puces électroniques principales (1), chaque puce électronique principale (1) comportant une surface avant (1A) comportant une pluralité de connecteurs (11) et une surface arrière (1B) opposée à la surface avant (1A),
- une étape de dépôt d'au moins un composant électronique (2) sur chaque surface avant (1A) de chaque puce électronique principale (1), chaque composant électronique (2) comportant une surface avant (2A) comportant une pluralité de connecteurs (21) et une surface arrière (2B) opposée à la surface avant (2A), la surface arrière (2B) du composant électronique (2) étant positionnée face à la surface avant (1A) de la puce électronique principale (1) de manière à ce que le composant électronique (2) soit en saillie verticale de la surface avant (1A) de la puce électronique principale (1),
- une étape de réalisation d'une pluralité d'interconnexions tridimensionnelles indépendantes (12) réalisées par dépôt métallique de manière, d'une part, à relier un connecteur (21) du composant électronique (2) à un connecteur (11) de de la puce électronique principale (1) et, d'autre part, à former, pour chaque interconnexion indépendante, un plot de connexion (120) relié à la surface avant (1A) de ladite puce électronique principale (1),
- une étape de solidarisation, pour chaque interconnexion indépendante, d'au moins une bille conductrice principale (13) directement audit plot de connexion (120), ladite bille conductrice principale (13) étant adaptée pour se connecter à un circuit imprimé (CI), la bille conductrice principale (13) s'étendant en avant de la surface avant (2A) du composant électronique (2), et
- une étape de découpe de la galette pour former des systèmes électroniques (S) indépendants comportant un boitier formé par la puce électronique principale (1).

## Patentansprüche

1. Elektronisches System (S), aufweisend:
- einen elektronischen Hauptchip (1), der ein Gehäuse bildet, wobei der elektronische Hauptchip (1) eine Vorderseite (1A) mit einer Vielzahl von Anschlüssen (11) und eine der Vorderseite (1A) gegenüberliegende Rückseite (1B) aufweist;
- mindestens eine elektronische Komponente (2) mit einer Vorderseite (2A) mit einer Vielzahl von Anschlüssen (21) und einer der Vorderseite (2A) gegenüberliegenden Rückseite (2B);
- wobei die Rückseite (2B) der elektronischen Komponente (2) der Vorderseite (1A) des elektronischen Hauptchips (1) zugewandt positioniert ist, so dass die elektronische Komponente (2) vertikal aus der Vorderseite (1A) des elektronischen Hauptchips (1) herausragt;
- wobei eine Vielzahl von unabhängigen dreidimensionalen Verbindungen durch Metallabscheidung einen Anschluss (21) der elektronischen Komponente (2) mit einem Anschluss (11) des elektronischen Hauptchips (1) verbindet, wobei mindestens eine dreidimensionale Verbindung ein Formverhältnis von Breite zu Höhe von weniger als 1:1,5 aufweist,
wobei das System **dadurch gekennzeichnet ist, dass**
- für jede unabhängige Verbindung mindestens ein Verbindungsstück (120) mit der Vorderseite (1A) des elektronischen Hauptchips (1) verbunden ist und gleichzeitig mit der dreidimensionalen Verbindung durch Metallabscheidung gebildet wird, und
- für jede unabhängige Verbindung mindestens eine Hauptleitkugel (13) direkt mit dem Verbindungsstück verbunden ist und zur Verbindung mit einer gedruckten Schaltung (CI) geeignet ist, wobei sich die Hauptleitkugel (13) vor der Vorderseite (2A) der elektronischen Komponente (2) erstreckt.

2. Elektronisches System (S) nach vorherigem Anspruch, wobei das elektronische System (S) eine Verkapselungsschicht (14) aufweist, so dass die Vorderseite (1A) des elektronischen Hauptchips (1) und ein Abschnitt der Hauptleitkugel (13) verkapselt wird.

3. Elektronisches System (S) nach einem der Ansprüche 1 bis 2, wobei das elektronische System (S) mindestens eine Hilfsleitkugel (130) aufweist, die kleiner ist als die Hauptleitkugel (13), die mit der dreidimensionalen Verbindung (12) verbunden ist, wobei die Gesamtheit der Leitkugeln (13, 130) eine einzige Verbindungsebene (P) definiert.

4. Elektronisches System (S) nach einem der Ansprüche 1 bis 3, wobei mindestens eine dreidimensionale Verbindung ein Formverhältnis von Breite zu Höhe von weniger als 1:3 aufweist.

5. Verfahren zur Herstellung eines elektronischen Systems (S) nach einem der Ansprüche 1 bis 4, umfassend:
- einen Schritt des Bereitstellens eines Wafers mit einer Vielzahl von elektronischen Hauptchips (1), wobei jeder elektronische Hauptchip (1) eine Vorderseite (1A) mit einer Vielzahl von Anschlüssen (11) und eine der Vorderseite (1A) gegenüberliegende Rückseite (1B) aufweist,
- einen Schritt des Aufbringens mindestens einer elektronischen Komponente (2) auf jede Vorderseite (1A) jedes elektronischen Hauptchips (1), wobei jede elektronische Komponente (2) eine Vorderseite (2A) mit einer Vielzahl von Anschlüssen (21) und eine der Vorderseite (2A) gegenüberliegende Rückseite (2B) aufweist, wobei die Rückseite (2B) der elektronischen Komponente (2) der Vorderseite (1A) des elektronischen Hauptchips (1) zugewandt positioniert ist, so dass die elektronische Komponente (2) vertikal aus der Vorderseite (1A) des elektronischen Hauptchips (1) herausragt,
- einen Schritt des Herstellens einer Vielzahl unabhängiger dreidimensionaler Verbindungen (12), die durch Metallabscheidung hergestellt werden, so dass einerseits einen Anschluss (21) der elektronischen Komponente (2) mit einem Anschluss (11) des elektronischen Hauptchips (1) verbunden wird und andererseits für jede unabhängige Verbindung ein mit der Vorderseite (1A) des elektronischen Hauptchips (1) verbundenes Verbindungsstück (120) gebildet wird,
- einen Schritt des festen Verbindens, für jede unabhängige Verbindung, mindestens einer Hauptleitkugel (13) direkt am Verbindungsstück (120), wobei die Hauptleitkugel (13) geeignet ist, mit einer gedruckten Schaltung (CI) verbunden zu werden, wobei sich die Hauptleitkugel (13) vor der Vorderseite (2A) der elektronischen Komponente (2) erstreckt, und
- einen Schritt des Ausschneidens des Wafers, um unabhängige elektronische Systeme (S) mit einem Gehäuse zu bilden, das von dem elektronischen Hauptchip (1) gebildet wird.

## Claims

1. An electronic system (S) comprising:
- a main electronic chip (1) forming a package, said main electronic chip (1) comprising a front surface (1A) comprising a plurality of connectors (11) and a rear surface (1B) opposite the front surface (1A);
- at least one electronic component (2) comprising a front surface (2A) comprising a plurality of connectors (21) and a rear surface (2B) opposite the front surface (2A);
- the rear surface (2B) of the electronic component (2) being positioned in front of the front surface (1A) of the main electronic chip (1) so that the electronic component (2) projects vertically from the front surface (1A) of the main electronic chip (1);
- a plurality of independent three-dimensional interconnections made by metal deposition connecting a connector (21) of the electronic component (2) to a connector (11) of the main electronic chip (1), at least three-dimensional interconnection having an aspect ratio, width to height, of less than 1:1.5
the system being **characterized by**
- for each independent interconnection, at least one contact pad (120) connected to the front surface (1A) of said main electronic chip (1) and formed by metal deposition simultaneously with the three-dimensional interconnection; and
- for each independent interconnection, at least one main conductive ball (13) rigidly secured to said contact pad and suitable for being connected to a printed circuit (CI), the main conductive ball (13) extending forward of the front surface (2A) of the electronic component (2).

2. The electronic system (S) according to the preceding claim, in which the electronic system (S) comprises an encapsulation layer (14) to encapsulate the front surface (1A) of the main electronic chip (1) and a portion of the main conductive ball (13).

3. The electronic system (S) according to one of claims 1 to 2, wherein the electronic system (S) comprises at least one auxiliary conductive ball (130), of smaller dimensions than the main conductive ball (13), which is connected to the three-dimensional interconnection (12), the set of conductive balls (13, 130) defining a single connection plane (P).

4. The electronic system (S) according to any of claims 1 to 3, in which at least one three-dimensional interconnection has an aspect ratio, width to height, of less than 1:3.

5. A method for manufacturing an electronic system (S) according to one of claims 1 to 4, comprising:
- a step of providing a wafer comprising a plurality of main electronic chips (1), each main electronic chip (1) comprising a front surface (1A) comprising a plurality of connectors (11) and a rear surface (1B) opposite the front surface (1A),
- a step of depositing at least one electronic component (2) on each front surface (1A) of each main electronic chip (1), each electronic component (2) comprising a front surface (2A) comprising a plurality of connectors (21) and a rear surface (2B) opposite the front surface (2A), the rear surface (2B) of the electronic component (2) being positioned in front of the front surface (1A) of the main electronic chip (1) so that the electronic component (2) projects vertically from the front surface (1A) of the main electronic chip (1),
- a step for producing a plurality of independent three-dimensional interconnections (12) by metal deposition, so as, on the one hand, to connect a connector (21) of the electronic component (2) to a connector (11) of the main electronic chip (1) and, on the other hand, to form, for each independent interconnection, a contact pad (120) connected to the front surface (1A) of said main electronic chip (1),
- a step of securing, for each independent interconnection, at least one main conductive ball (13) directly to said contact pad (120), said main conductive ball (13) being adapted to connect to a printed circuit (CI), the main conductive ball (13) extending forward of the front surface (2A) of the electronic component (2), and
- a step of cutting the wafer to form independent electronic systems (S) comprising a package formed by the main electronic chip (1).
